# EUROPEAN PATENT APPLICATION

(11) **EP 3 340 274 A1**
(43) Date of publication of application: **27.06.2018**
(21) Application number: 16460097.5
(22) Date of filing: 24.12.2016
(51) Int. Cl.: H01J 37/34, H01J 37/32, C23C 14/00, C23C 14/34

(54) **MAGNETRON SPUTTERING DEVICE**

(71) Applicant: WINDLIPIE spólka z ograniczona odpowiedzialnoscia spólka komandytowa, 62-586 Slawsk (PL)
(72) Inventor: Marszalek, Konstanty, 31-358 Kraków (PL)

(57) **Abstract**

A magnetron sputtering device wherein gas or a mixture of process gases are fed into its ionization region, characterized in that the device's anode (3) is built in a form of a two-wall metal chamber into which gas or a process gas mixture is fed via a feeding channel (4), said channel being connected to an external gas dispensing installation. Anode (3) surrounds the magnetron sputtering device (1), and, in the internal wall of anode (3) at the height of the device's ionization region, there are symmetrically arranged outlet openings (5) for gas or process gas mixture for feeding gas into the vicinity of a target (2).

## Description

The invention provides a magnetron sputtering device intended for coating with thin coating layers by means of ion sputtering.

Magnetron sputtering devices provide a source of material from which in a ion sputtering process a thin layer is formed on coating substrates. One of the elements of a sputtering device, being cathode in the ionization and plasma generation process, is a target from which, by means of ions originated from ionization of gas fed to a vacuum chamber, atoms are ejected to form a layer. Sputtering devices are of a cylindrical or parallelepiped shape. A sputtering device is surrounded by a metallic anode. Said anode is a metallic electrode with polarization opposite to the one of the cathode.

From patent specification PL 218274 B1 a magnetron sputtering device is known, said device being equipped with a magnetic circuit based on a ferromagnetic core as well as a magnet and cathode. The sputtering device has, attached to its thermoelectric module, a metallic radiator along with a fan, where the cold side of the thermoelectric module is attached to the metallic cathode core which is insulated from anode by means of a cylindrical sheath of an insulating material and spacing rings made of an insulating material. The spacing rings provide thereby a hold to fix the magnetron cathode of the material to be sputtered, where the magnetic circuit is based on a ferromagnetic core and on a magnet in a form of a ring and core, to which the cathode is directly pressed.

Magnetron sputtering devices are known that are equipped with gas dispensing systems. Such gas dispensing systems are varied according to the cathode size and shape.

From patent application US 5,952,061 a solution is known for a gas dispensing system being a tube inserted into vacuum through a vacuum chamber wall, for dispensing H₂, Ar, He, Ne, Kr gases.

Another solution is a gas distribution system for a cylindrical magnetron sputtering device known from patent US 9,228,254 B2 "Cathode sputtering gas distribution apparatus". The system comprises an array of tubes for feeding gas to the vicinity of magnetron targets having a series of outlet apertures for gas or gas mixture. For larger sizes of sputtering devices, feeding the same amount of gas for each portion of the target so as to maintain uniform plasma density that determines homogeneity of the thickness of the layer being built becomes problematic. In order to provide homogeneous plasma density, complex arrays of tubes for feeding gas to ionization region above the target are used.

For the purpose of deposition on large-size substrates, with the use of a parallelepiped magnetron sputtering device, complex systems for distribution of gases are used such as the one known from patent application WO 2016/124517 A1 "Device for coating a substrate having a large surface area" an a gas distribution system in a form of a large chamber with apertures arranged over the entire process area.

It is the object of the present invention to provide a magnetron sputtering device of a simple construction which enables uniform coverage of a surface on its entire area without use of expensive and complex tubing systems.

The concept of a magnetron sputtering device to which gas or a mixture of process gases are fed, is characterized in that its anode is built in a form of a closed two-wall metal chamber into which gas or a mixture of process gases are fed through a feeding channel connected to an external gas dispensing installation. Anode surrounds the magnetron sputtering device and in the inner anode wall at the height of the ionization region there are symmetrically arranged outlet openings for gas or process gas mixture that feed gas to the vicinity of a target.

A magnetron sputtering device according to the invention integrated with a gas discharge system eliminates all disadvantages of tubes for gas distribution within the vacuum chamber.

Anode does not constitute an additional dispensing system which in a form of tubes or chambers would disturb the magnetic field within the process region and may be used both for cylindrical and for parallelepiped magnetron sputtering devices. Anode is a constant and unchangeable element of the sputtering system and minor changes in its size do not affect the configuration of magnetic or electric field.

The subject solution simplifies assembly of the construction and makes it possible to avoid the use of gas distribution systems known in the prior art that cause disturbances in the electric field within the glow discharge region. At the same time, in particular in sputtering devices of a larger size, the invention enables obtaining uniform plasma density and thereby uniform thickness of coated layers on the entire deposition area.

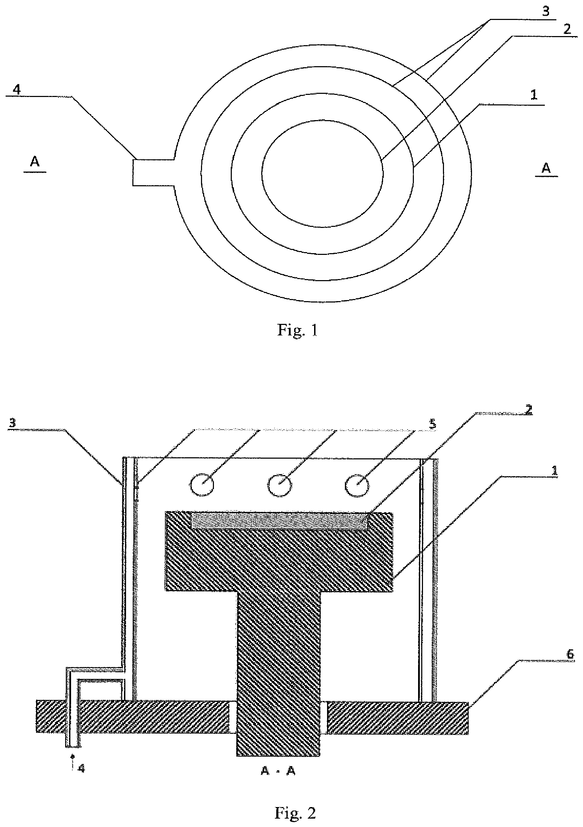

The object of the invention is illustrated in an embodiment in the drawing where fig. 1 shows a schematic top view of a magnetron sputtering device, and fig. 2 shows a cross-sectional view along line A-A marked in fig. 1.

A cylindrical magnetron sputtering device comprises anode 3 in a form or a closed two-wall chamber the walls of which differ in their radius. Into anode 3 gas or a mixture of process gases are fed via a feeding channel 4 connected to an external gas dispensing installation. Anode 3 surrounds the magnetron sputtering device 1. In the inner wall of anode 3, at the height of its ionization region there are regularly arranged outlet openings 5 for gas or a process gas mixture for feeding gas into the vicinity of a sputtered target 2. The feeding channel 4 is positioned in the outer wall of the chamber 6, outside the glow discharge region and does not affect the sputtering process. This ensures constant uniform gas inflow and uniform plasma density over the entire area of the target 3 regardless of its size.

## Claims

1. A magnetron sputtering device wherein into its ionization region gas or a mixture of process gases are fed, **characterized in that** its anode (3) is built in a form of a two-wall metal chamber into which gas or a process gas mixture is fed via a feeding channel (4) connected to an external gas dispensing installation where anode (3) surrounds the magnetron sputtering device (1), and in the internal wall of anode (3) at the height of its ionization region there are symmetrically arranged outlet openings (5) for gas or process gas mixture for feeding gas into the vicinity of a target (2).
